(19) Europäisches Patentamt
European Patent Office
Office européen des brevets

(11) EP 4 492 101 A1

(12) # EUROPEAN PATENT APPLICATION
published in accordance with Art. 153(4) EPC

(43) Date of publication:
**15.01.2025 Bulletin 2025/03**

(21) Application number: **23766765.4**

(22) Date of filing: **06.03.2023**

(51) International Patent Classification (IPC):
***G02B 3/00*** (2006.01) ***G02B 5/02*** (2006.01)
***H01L 31/12*** (2006.01)

(52) Cooperative Patent Classification (CPC):
**G02B 3/00; G02B 5/02; H01L 31/12**

(86) International application number:
**PCT/JP2023/008203**

(87) International publication number:
**WO 2023/171589 (14.09.2023 Gazette 2023/37)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **10.03.2022 JP 2022036953**

(71) Applicant: **Kyocera Corporation**
**Kyoto-shi, Kyoto 612-8501 (JP)**

(72) Inventors:
- **YAMASAKI Sho**
  **Kyoto-shi, Kyoto 612-8501 (JP)**
- **HONDA Megumi**
  **Kyoto-shi, Kyoto 612-8501 (JP)**

(74) Representative: **Viering, Jentschura & Partner mbB**
**Patent- und Rechtsanwälte**
**Am Brauhaus 8**
**01099 Dresden (DE)**

(54) **DIFFUSION PLATE, LIGHT-EMITTING DEVICE, AND SENSOR MODULE**

(57) Provided is a diffuser having a microlens array including a first lens. In a longitudinal section, the first lens has an outline including a first shape region including an apex of the outline, a change point positioned at an end of the first shape region, and a second shape region positioned opposite to the first shape region to interpose the change point. The first shape region has a shape according to formula (1), and the second shape region has a shape not according to formula (1) and includes a region larger in inclination angle than the shape according to formula (1).

FIG. 2

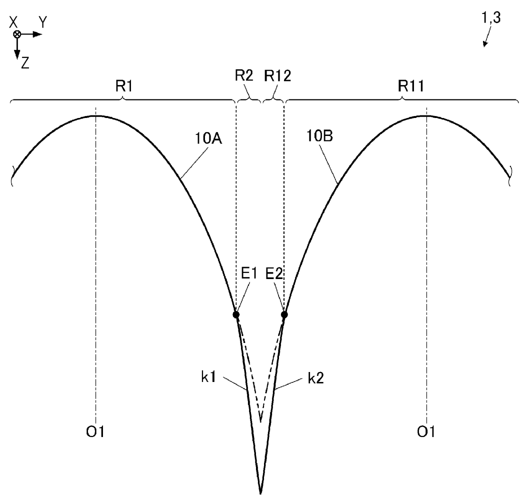


EP 4 492 101 A1

## Description

TECHNICAL FIELD

The present disclosure relates to a diffuser, a light emitting device, and a sensor module.

BACKGROUND OF INVENTION

Japanese Unexamined Patent Application Publication No. 2003-4907 describes a microlens array including a plurality of lenses disposed to have irregular vertex intervals for a reduction of interference fringes.

SUMMARY

SOLUTION TO PROBLEM

According to the present disclosure, a diffuser includes a microlens array including a first lens. The first lens has an outline in a longitudinal section, and the outline includes a first shape region including an apex of the outline, a change point positioned at an end of the first shape region, and a second shape region positioned opposite to the first shape region to interpose the change point. The first shape region has a shape according to formula (1) to be described later. The second shape region has a shape not according to formula (1) and includes a region larger in inclination angle than the shape according to formula (1).

According to the present disclosure, a light emitting device includes a light emitting element, and the diffuser positioned on a path of light emitted from the light emitting element.

According to the present disclosure, a sensor module includes the light emitting device, and a light receiving device configured to receive light emitted from the light emitting device.

ADVANTAGEOUS EFFECT

The present disclosure can provide a diffuser that can reduce influence of diffracted light and has excellent light distribution characteristics, as well as a light emitting device and a sensor module each including the diffuser.

BRIEF DESCRIPTION OF THE DRAWINGS

FIG. 1A is a longitudinal sectional view of a diffuser according to embodiment 1 of the present disclosure.
FIG. 1B is a plan view of the diffuser according to embodiment 1 of the present disclosure.
FIG. 1C is a plan view illustrating arrangement of a plurality of lenses according to a variation, in the diffuser according to embodiment 1 of the present disclosure.
FIG. 2 is a view illustrating outlines of a first lens and a second lens according to embodiment 1.
FIG. 3A is an explanatory view on a function of foot portions of the lenses according to embodiment 1.
FIG. 3B is an explanatory view on a function of foot portions of lenses according to a comparative example.
FIG. 4A is a chart indicating lens characteristics according to embodiment 1.
FIG. 4B is a chart indicating lens characteristics according to a comparative example.
FIG. 5 is a view illustrating outlines of a first lens and a second lens according to embodiment 2.
FIG. 6 is a chart indicating lens characteristics according to embodiment 2.
FIG. 7A is a plan view indicating positions of change points.
FIG. 7B is an enlarged plan view illustrating part of FIG. 7A.
FIG. 8 is a graph indicating a relationship between a width between change points and a lens inclination angle at a change point.
FIG. 9 is a view illustrating outlines of a first lens and a second lens according to embodiment 3.
FIG. 10 is a chart indicating lens characteristics according to embodiment 3.
FIG. 11A is a chart indicating light distribution characteristics of a diffuser according to embodiment 3.
FIG. 11B is a chart indicating light distribution characteristics of a diffuser according to a comparative example.
FIG. 12 is a view illustrating outlines of a first lens and a second lens according to embodiment 4.
FIG. 13 is a chart indicating lens characteristics according to embodiment 4.
FIG. 14 is an explanatory view on an exemplary method of manufacturing a diffuser according to an embodiment.
FIG. 15 is a longitudinal sectional view of a diffuser according to embodiment 5.

FIG. 16 is a view of a light emitting device and a sensor module according to an embodiment of the present disclosure.

DESCRIPTION OF EMBODIMENTS

Embodiments of the present disclosure will be described in detail hereinafter with reference to the drawings. The following description will refer to a Z direction along an optical axis O1 of a lens 10 as a vertical direction, and an X-Y direction in which a plurality of lenses 10 is aligned as a horizontal direction.

(Embodiment 1)

FIGs. 1A to 1C are a longitudinal sectional view and a plan view of a diffuser according to embodiment 1 of the present disclosure, and a plan view illustrating arrangement of a plurality of lenses according to a variation, respectively. FIG. 1A illustrates a section taken along line A-A in FIG. 1B.

Embodiment 1 provides a diffuser 1 including a microlens array 3 as illustrated in FIGs. 1A and 1B. The diffuser 1 may include a transparent substrate 2 such as a glass substrate, and the microlens array 3 positioned on the transparent substrate 2. The microlens array 3 includes the plurality of lenses 10.

The microlens array 3 may be made of a material such as an acrylic resin, an epoxy resin, or a silicone resin. The transparent substrate 2 may be made of a material such as a borosilicate glass.

Each of the lenses 10 may be a convex lens having a vertex positioned on one side. The plurality of lenses 10 may be arranged in two dimensional directions along an appropriate plane S1 (a flat plane in FIG. 1A), and may each include the optical axis (i.e., a principal axis) O1 along a normal line of the plane S1. The plurality of lenses 10 may be coupled together at portions adjacent to the plane S1. The plurality of lenses 10 may be integrated as an integrally molded product.

The plurality of lenses 10 may be positioned to have even vertex intervals as illustrated in FIG. 1B, or may be positioned to have uneven vertex intervals as illustrated in FIG. 1C.

In the configuration described above, when light enters from one surface (e.g., the surface provided with the vertexes of the lenses 10 in the vertical direction: a -Z direction) of the diffuser 1, the light is refracted by the plurality of lenses 10 and diffused light can be outputted from the other surface (i.e., in a Z direction) of the diffuser 1.

<Details of lens>

The plurality of lenses 10 includes a first lens 10A. The plurality of lenses 10 further includes a second lens 10B disposed adjacent to the first lens 10A, and a plurality of lenses 10C in contact with the first lens 10A. One of the plurality of lenses 10C corresponds to the second lens 10B.

The following description is mainly made to details of the first lens 10A and the second lens 10B. Characteristics of the first lens 10A and the second lens 10B to be described hereinafter may apply to all the lenses 10 included in the microlens array 3, or may apply to some of the lenses 10. The characteristics exhibit higher effects as a larger number of lenses 10 have the characteristics. The lenses 10 having the characteristics may account for 50% or more, or 80% or more of all the lenses 10. In another case where the diffuser 1 is provided with a light transmissive region Rc (see FIG. 16), the lenses 10 having the characteristics may account for 50% or more, or 80% or more of all lenses 10 included in the transmissive region Rc. The transmissive region Rc means a preliminarily defined region as a region allowing light transmission, and may be defined by specifications or the like.

FIG. 2 is a view illustrating outlines of the first lens 10A and the second lens 10B according to embodiment 1.

The outlines in FIG. 2 illustrate outer shapes in a longitudinal section including the optical axis O1 of the first lens 10A and the optical axis O1 of the second lens 10B. The outer shapes are identical or similar also in a longitudinal section perpendicular to a boundary between the first lens 10A and the second lens 10B and including no optical axis O1. A longitudinal section perpendicular to a boundary means a longitudinal section perpendicular in a planar view to a boundary line between the first lens 10A and the second lens 10B (the boundary line appears as a straight line in a planar view). A longitudinal section may mean a section along an optical axis, or may mean a section perpendicular to the plane along which the plurality of lenses 10 is arranged.

In a longitudinal section, the outline of the first lens 10A includes a first shape region R1 including an apex of the outline, a change point E1 positioned at an end of the first shape region R1, and a second shape region R2 positioned opposite to the first shape region R1 to interpose the change point E1. The outline of the second lens 10B includes a first shape region R11 including an apex of the outline, a change point E2 positioned at a foot end of the first shape region R11, and a second shape region R12 extending from the change point E2 and disposed on a foot side.

The first shape regions R1 and R11 each have a shape according to formula (1).
[Math. 1]

$$z = \frac{\frac{h^2}{r}}{1 + \sqrt{1 - \frac{(1+k)}{r^2} h^2}} \quad \cdots (1)$$

In this formula, z is a sag, h is a radial distance from an optical axis, r is a lens radius, and k is a conic constant. Constant values (r and k) in formula (1) for the first lens 10A may be identical to constant values (r and k) in formula (2) for the second lens 10B.

The second shape regions R2 and R12 each have a shape not according to formula (1), and include inclined portions k1 and k2 larger in inclination angle than the shape according to formula (1). An inclination angle means an acute angle formed between the horizontal direction and a tangent of the outline. Each of the inclined portions k1 and k2 may include a straight line, a curved line to be convex outward, a curved line to be concave outward, or a line mixedly including any two or three of the straight line, the convex curved line, and the concave curved line. In FIG. 2, the outlines according to formula (1) include portions disposed on foot sides of the change points E1 and E2 and indicated by two-dot chain lines. A foot side means a lower side of the outline of the first lens 10A assuming that the first lens 10A has a vertex (e.g., an intersection between a lens surface and the optical axis O1) on a higher side.

The change point E1 is a boundary point between the first shape region R1 having the shape according to formula (1) and the second shape region R2 having the shape not according to formula (1). The change point E1 corresponds to a point changing from the shape according to formula (1) to the shape not according to formula (1) when a point is moved in one direction along the outline of the first lens 10A from an apex of the first lens 10A in a longitudinal section.

Each of the change points E1 and E2 may be a point having a discontinuous curvature or a point having a discontinuous curvature position differential. Being discontinuous includes, as well as strict discontinuity, a case where a curvature or its position differential changes by one-eighth or more of a difference between a maximum value and a minimum value of the curvature or the position differential of the lens displaced radially by one-twenty fourth of the lens radius.

FIGs. 3A and 3B are explanatory views on a function of a foot portion of a lens. FIG. 3A is a view according to embodiment 1 whereas FIG. 3B is a view according to a comparative example. The comparative example of FIG. 3B indicates a function of a configuration having outer shapes according to formula (1) to a boundary between a pair of adjacent lenses 10.

In the shape according to formula (1) to the boundary as illustrated in FIG. 3B, perpendicular incident light rays i11 and i12 at two different points are refracted at substantially identical angles (i.e., $\varphi 11 \approx \varphi 12$) near a point p1 corresponding to the change point E1. Refracted light rays o11 and o12 having phases uniformly shifted by such refraction are likely to overlap at an irradiation point to interfere with each other. In contrast, when the first shape region R1 and the second shape region R2 are disposed to interpose the change point E1 as illustrated in FIG. 3A, perpendicular incident light rays i1 and i2 at two different points interposing the change point E1 are refracted at relatively largely different angles (i.e., $\varphi 1 \neq \varphi 2$). Refracted light rays o1 and o2 having phases uniformly shifted after such refraction are not close to each other at an irradiation point so as to be less likely to interfere with each other.

FIG. 4A is a chart indicating lens characteristics according to embodiment 1. FIG. 4B is a chart indicating lens characteristics according to the comparative example. FIGs. 4A and 4B are graphs having a transverse axis indicating a radial distance (in other words, a position) from the optical axis O1 of the first lens 10A, a left ordinate axis indicating a height of the first lens 10A assuming that the vertex has a zero point, and a right ordinate axis indicating an inclination angle of the first lens 10A. The same or a similar applies to graphs in FIGs. 6, 8, and 11 to be referred to later. The comparative example of FIG. 4B indicates characteristics of a lens having the shape according to formula (1) to a boundary of the lens, that is, a lens not including the change points E1 and E2.

As indicated by plotted characteristic lines in FIGs. 4A and 4B, the characteristic line has a gradient close to zero at a foot portion of the first lens 10A. This fact means that incident light rays at different positions in a range X having a gradient close to zero are refracted at substantially identical angles. Refracted light rays in the range X are applied to close positions on an irradiation surface of diffused light to be likely to generate interference fringes. Meanwhile, as indicated in a range C1 of FIG. 4A, the range X includes the change point E1 to cause a difference $\Delta\varphi$ in the inclination angle of the first lens 10A between both sides interposing the change point E1. The difference $\Delta\varphi$ causes dispersion in an irradiation direction of refracted light transmitting through the range X so as to reduce interference fringes generated on the irradiation surface of diffused light.

As described above, in the diffuser 1 according to embodiment 1, the plurality of lenses 10 (e.g., the first lens 10A and the second lens 10B) included in the microlens array 3 has the outlines including the change points E1 and E2 in a longitudinal section, to reduce interference fringes generated on the irradiation surface of diffused light.

Furthermore, in embodiment 1, the diffuser 1 can reduce interference fringes with the functions of the change points E1 and E2 even if the plurality of lenses 10 in the microlens array 3 does not have largely uneven vertex intervals. This achieves effects of reduced interference fringes as well as excellent light distribution characteristics of diffused light. These effects can be exhibited for the following reason. Conventional approaches for reduction of interference fringes include arranging the lenses 10 in the microlens array 3 to have uneven vertex intervals. However, excessively uneven vertex intervals fail to achieve diffused light distribution expected from a geometric design for each lens, and causes a problem that the diffused light has an irradiation range with a blurred periphery. This problem is caused by ununiform appearance of the foot portions of the lenses due to the uneven vertex intervals. For example, the foot portion of each lens is overlapped with an adjacent lens to be hidden, or is far from an adjacent lens to appear wider. Such ununiformity fails to achieve light irradiation expected from the design and causes blurred irradiation at a periphery of the irradiation range of applied light due to refraction at the foot portion. In embodiment 1, the diffuser 1 can reduce interference fringes without largely uneven vertex intervals of the lenses 10. This can reduce such blurred applied light at the periphery of the irradiation range, to achieve excellent light distribution characteristics.

(Embodiment 2)

FIG. 5 is a view illustrating outlines of a first lens and a second lens according to embodiment 2. The outlines in FIG. 5 illustrate outer shapes in a longitudinal section including the optical axis O1 of the first lens 10A and the optical axis O1 of the second lens 10B. The outer shapes are identical or similar also in a longitudinal section at a position displaced from the optical axis O1. In FIG. 5, the outlines according to formula (1) include portions disposed on foot sides of the change points E1 and E2 and indicated by two-dot chain lines.

Embodiment 2 provides a diffuser 1A configured in the same or a similar manner to embodiment 1 except for difference in the shapes around the boundary between the first lens 10A and the second lens 10B. Description is hereinafter made to difference from embodiment 1.

In a longitudinal section, the outlines of the first lens 10A and the second lens 10B include the first shape regions R1 and R11 including apexes of the outlines, the change points E1 and E2 positioned at foot ends of the first shape regions R1 and R11, and the second shape regions R2 and R12 extending from the change points E1 and E2 and disposed on foot sides. An apex may mean a higher summit in a longitudinal section.

The first shape regions R1 and R11 each have the shape according to formula (1) mentioned above.

The second shape regions R2 and R12 each have the shape not according to formula (1), and include inclined portions k1A and k2A larger in inclination angle than the shape according to formula (1), and concave arc portions k3A and k4A positioned in a boundary portion between the first lens 10A and the second lens 10B.

The change points E1 and E2 may be positioned at boundaries between the first shape regions R1 an R11 and the second shape regions R2 and R12, and may each be a point having a discontinuous curvature or a point having a discontinuous curvature position differential.

Each of the inclined portions k1A and k2A may include a straight line, a curved line to be convex outward, a curved line to be concave outward, or a line mixedly including any two or three of the straight line, the convex curved line, and the concave curved line.

The concave arc portions k3A and k4A each have a concave arc shape to be concave outward. A concave arc shape conceptionally includes, as well as a strict concave arc shape, a shape approximate to the concave arc shape, such as a concave shape having a gently changing curvature. The concave arc portions k3A and k4A include respective ends having a width W3 that may be smaller than a width W1 between the change points E1 and E2. The concave arc portions k3A and k4A have a bottom that may be as high as or different in height from a boundary point vB0 between the first lens 10A and the second lens 10B in a case where the shapes according to formula (1) are provided continuously to the foot portions.

FIG. 6 is a chart indicating lens characteristics according to embodiment 2. In the first lens 10A according to embodiment 2, the change point E1 is included in the range X where the plotted characteristic line has a gradient close to zero, to cause the difference $\Delta\varphi$ in the inclination angle of the first lens 10A between the both sides interposing the change point E1. Furthermore, the lens boundary portion includes the concave arc portion k3A so as to have ununiformity in the inclination angle of the first lens 10A and large dispersion of a light refraction angle in a range C2 indicated in FIG. 6. Accordingly, refracted light having transmitted through the range X is appropriately dispersed in terms of the irradiation direction so as to further reduce interference fringes generated on the irradiation surface of diffused light. Moreover, the concave arc portion k3A facilitates formation of the boundary portion between the first lens 10A and the second lens 10B.

<Position of change point>

FIG. 7A is a plan view indicating positions of change points. FIG. 7B is an enlarged plan view illustrating part of FIG. 7A. FIG. 7A exemplarily illustrates the plurality of lenses 10 (10A, 10B, and 10C) arranged unevenly. The same or a similar applies to a case where the plurality of lenses 10 (10A, 10B, and 10C) arranged evenly.

The change point E1 of the first lens 10A may be positioned along a boundary line B1 between the first lens 10A and the second lens 10B in a planar view as illustrated in FIG. 7A. Furthermore, the change point E1 may be positioned in an entire circumferential region of the first lens 10A along boundary lines B1 and B2 between the first lens 10A and the plurality of lenses 10C in contact with the first lens 10A. In the same or a similar manner, the change point E2 of the second lens 10B may be positioned along the boundary line B1 between the first lens 10A and the second lens 10B in a planar view.

The width W1 (see FIG. 7B) between the change point E1 of the first lens 10A and the change point E2 of the second lens 10B and an average distance L0 (to be described later) between vertexes of the first lens 10A may have a relationship expressed by formula (2).

$$1/50 \cdot L0 \leq W1 \leq 1/4 \cdot L0 \ ... \ (2)$$

In this formula, the width W1 means a distance in a planar direction in a longitudinal section perpendicular to the boundary line B1 between the first lens 10A and the second lens 10B. A longitudinal section perpendicular to the boundary line B1 (appearing as a straight line in a planar view) means a longitudinal section perpendicular to the boundary line B1 in a planar view. The average distance L0 between vertexes of the first lens 10A means an average of distances L1 to L6 between the vertex of the first lens 10A and vertexes of the plurality of lenses 10C in contact with the first lens 10A. The distances L1 to L6 mean distances in a planar view, that is, distances in the horizontal direction. If the plurality of lenses 10C and the first lens 10A are equal in height, a distance in a planar view is equal to a distance in a three dimensional space.

The change points E1 and E2 are positioned as described above to sufficiently achieve dispersion in the refraction angle of light refracted at the foot portion of the first lens 10A and further reduce interference fringes generated on the irradiation surface of diffused light.

FIG. 8 is a graph indicating a relationship between a width between change points and a lens inclination angle at a change point. In a longitudinal section (see FIG. 5) perpendicular to the boundary line B1 between the first lens 10A and the second lens 10B, the width W1 between the change points E1 and E2 and an inclination angle $\theta$ (FIG. 5) of the first lens 10A at the change point E1 may have a relationship expressed by formula (3).

$$0.01 \times \theta \leq W1 \leq 0.04 \times \theta \ ... \ (3)$$

In this formula, the inclination angle $\theta$ means an angle formed between a tangent at the change point E1 (a tangent adjacent to the first shape region R1) and a horizontal line in the longitudinal section. This relationship indicates that the width W1 and the inclination angle $\theta$ are included in a hatched region in the graph of FIG. 8.

The change points E1 and E2 are positioned to satisfy the relationship according to formula (3) to sufficiently achieve dispersion into a plurality of directions of the refraction angle of light refracted at the foot portion of the first lens 10A and causing interference fringes, and further reduce interference fringes generated on the irradiation surface of diffused light.

At least one of the relationship between the width W1 between the change points E1 and E2 and the average distance L0 between vertexes and the relationship between the width W1 between the change points E1 and E2 and the inclination angle $\theta$ may be established in embodiment 1 described above and embodiments 3 and 4 to be described later.

(Embodiment 3)

FIG. 9 is a view illustrating outlines of a first lens and a second lens according to embodiment 3. The outlines in FIG. 9 illustrate outer shapes in a longitudinal section including the optical axis O1 of the first lens 10A and the optical axis O1 of the second lens 10B. The outer shapes are identical or similar also in a longitudinal section at a position displaced from the optical axis O1. In FIG. 9, the outlines according to formula (1) include portions disposed on foot sides of the change points E1 and E2 and indicated by two-dot chain lines.

Embodiment 3 provides a diffuser 1B configured in the same or a similar manner to embodiment 2 except for difference in the height around the boundary between the first lens 10A and the second lens 10B. Description is hereinafter made to difference from embodiment 2.

In embodiment 3, the outlines in a longitudinal section of the first lens 10A and the second lens 10B include the first shape regions R1 and R11, the second shape regions R2 and R12, and the change points E1 and E2, in the same or a similar manner to embodiment 2. Furthermore, the second shape regions R2 and R12 include inclined portions k1B and k2B and concave arc portions k3B and k4B.

In embodiment 3, in a longitudinal section, the concave arc portions k3A and k4B have a boundary point B0 that may be positioned higher than the boundary point vB0 between the first lens 10A and the second lens 10B in a case where the shapes according to formula (1) are provided continuously to the foot portions. The boundary point B0 may mean a lower summit in a longitudinal section.

FIG. 10 is a chart indicating lens characteristics according to embodiment 3. In the first lens 10A according to embodiment 2, the change point E1 is included in the range X where the plotted characteristic line has a gradient close to zero, to cause the difference $\Delta\varphi B$ in the inclination angle of the first lens 10A between the both sides interposing the change point E1. Furthermore, the lens boundary portion includes the concave arc portion k3B so as to have ununiformity in the inclination angle of the first lens 10A and large dispersion of a light refraction angle in a range C3 indicated in FIG. 10.

Moreover, the concave arc portion k3B has a bottom positioned higher to decrease the difference $\Delta\varphi B$ in inclination angle. The small difference $\Delta\varphi B$ means that light transmitting through the second shape region R2 of the first lens 10A has a refraction angle close to the refraction angle according to formula (1). That is, this achieves a decrease in quantity of refracted light passing through the range X and deviating from the irradiation direction according to formula (1). Accordingly, the irradiation direction of refracted light passing through the range X is dispersed enough to reduce interference fringes but does not deviate largely from the irradiation direction expected from the lens geometric design. This can achieve a reduction of interference fringes generated on the irradiation surface of diffused light, and excellent light distribution characteristics of diffused light equal to the characteristics expected from the lens geometric design. Furthermore, the concave arc portion k3B having the bottom positioned higher facilitates formation of the boundary portion between the first lens 10A and the second lens 10B.

<Light distribution characteristics>

FIG. 11A is a chart indicating light distribution characteristics of a diffuser according to embodiment 3. FIG. 11B is a chart indicating light distribution characteristics of a diffuser according to a comparative example. FIG. 11A indicates an actually measured value of light distribution characteristics of the diffuser 1B according to embodiment 3 as a test target including the first lens 10A and the second lens 10B. In the diffuser 1B as a test target, all the lenses 10 in the microlens array 3 are evenly arranged and all the lenses 10 are shaped identically to the first lens 10A and the second lens 10B. In the comparative example of FIG. 11B, the diffuser is different from the diffuser 1B as a test target only in that each of the lenses has the shape according to formula (1) continuously to the boundary, and identical to the diffuser 1B as a test target in terms of the constants in formula (1) and arrangement of the plurality of lenses (arrangement inclusive of pitches). FIG. 11A and FIG. 11B are graphs each having a transverse axis indicating an angle $\Phi$ from a center of the diffuser assuming that the diffuser has 0 [deg] in a front direction (i.e. the Z direction), and an ordinate axis indicating intensity of diffused light received at a position equally distant from the center of the diffuser.

In the comparative example of FIG. 11B, the light distribution characteristics of the diffuser include interference fringes appearing in a range C11. Meanwhile, in embodiment 3 of FIG. 11A, the light distribution characteristics of the diffuser have a decrease in interference fringes. As indicated in ranges C12 and C13 in FIG. 11A and ranges C14 and C15 in FIG. 11B, embodiment 3 and the comparative example achieve equal light distribution characteristics at the periphery of the irradiation range of diffused light. That is, embodiment 3 achieves a reduced blur at the periphery of the irradiation range of diffused light. This means that, in embodiment 3, the diffuser 1B can reduce interference fringes and can achieve excellent light distribution characteristics of diffused light.

(Embodiment 4)

FIG. 12 is a view illustrating outlines of a first lens and a second lens according to embodiment 4. The outlines in FIG. 12 illustrate outer shapes in a longitudinal section including the optical axis O1 of the first lens 10A and the optical axis O1 of the second lens 10B. The outer shapes are identical or similar also in a longitudinal section at a position displaced from the optical axis O1. In FIG. 12, the outlines according to formula (1) include portions disposed on foot sides of the change points E1 and E2 and indicated by two-dot chain lines.

Embodiment 4 provides a diffuser 1C configured in the same or a similar manner to any one of embodiments 1 to 3 except for difference in the shapes of the second shape regions R2 and R12 of the first lens 10A and the second lens 10B.

In embodiment 4, the outlines in a longitudinal section of the first lens 10A and the second lens 10B include the first shape regions R1 and R11, the second shape regions R2 and R12, and the change points E1 and E2, in the same or a similar manner to any one of embodiments 1 to 3. The second shape regions R2 and R12 each have a shape not according to formula (1), and include inclined portions k1C and k2C larger in inclination angle than the shape according to formula (1).

In embodiment 4, the second shape regions R2 and R12 have outlines in an elliptical shape. An elliptical shape conceptionally includes, as well as a strict elliptical shape, a shape approximate to the elliptical shape, such as a shape having a gently changing curvature without any change in a sign for the curvature. The second shape regions R2 and R12 may be shaped to decrease widths W21, W22, ... toward the boundary point B0. The boundary point B0 between the first lens 10A and the second lens 10B may be as high as, lower than, or higher than the boundary point vB0 between the first lens 10A and the second lens 10B in a case where the shapes according to formula (1) are provided continuously to the foot portions.

FIG. 13 is a chart indicating lens characteristics according to embodiment 4. In the diffuser 1C according to embodiment 4, as indicated by a plotted characteristic line in FIG. 13, the change point E1 is included in the range X where the plotted characteristic line has a gradient close to zero in a case where the lens has the shape according to formula (1) continuously to the foot, for dispersion in the refraction angle of light passing through a portion closer to the foot with respect to the change point E1. This reduces overlap at the irradiation point of refracted light rays having uniformly shifted phases so as to reduce interference fringes generated on the irradiation surface of diffused light.

<Manufacturing method>

FIG. 14 is an explanatory view on an exemplary method of manufacturing the diffuser according to any one of embodiments 1 to 4. Manufacturing steps for the diffusers 1 and 1A to 1C may include master mold manufacturing steps (J1 to J3) of manufacturing a master mold for the microlens array 3, electrocast mold manufacturing steps (J4 to J6) of manufacturing an electrocast mold, secondary mold manufacturing steps (J7 and J8) of manufacturing a secondary mold, and imprinting steps (J9 to J11) of molding a resin on the glass substrate.

The master mold manufacturing steps include applying a resist resin 81 to a transfer substrate 80 and executing pretreatment (e.g., baking) (step J1), and then gray scale exposing the resist resin by laser lithography (step J2). Processing (step J3) follows exposure to obtain a master mold 82. Obtained through such steps is the master mold 82 having a mold shape including a plurality of arranged lens surfaces of the lenses 10.

The electrocast mold manufacturing steps include forming a conductive film 83 on a surface of the master mold 82 by sputtering or the like (step J4), forming a conductor 84 made of Ni (nickel) or the like and having the master mold 82 transferred by electroplating (step J5), and releasing and polishing the conductor 84 (step J6), to obtain an electrocast mold 85.

The secondary mold manufacturing steps include thermal imprinting a resin film 86 having thermoplasticity with the electrocast mold 85 (step J7), and peeling the resin film 86 from the electrocast mold 85 (step J8), to obtain a secondary mold 87 made of a resin material.

The imprinting steps include applying an ultraviolet curing transparent resin 89 or the like to a glass substrate 88 (step J9), and placing the secondary mold 87 onto the transparent resin 89 on the glass substrate 88 and curing the transparent resin 89 through ultraviolet irradiation or the like (step J10). the transparent resin 89 thus cured is released (step J11) to obtain an intermediate product 90 for the diffuser 1. Subsequently, characteristic evaluation of the intermediate product 90, dicing, visual inspection, and the like are executed to obtain the diffuser 1.

The manufacturing method described above enables manufacture with high molding accuracy of the microlens array 3 having fine properties such as a pitch of 100 $\mu$m or less and a curvature of 20 $\mu$m or less.

(Embodiment 5)

FIG. 15 is a longitudinal sectional view of a diffuser according to embodiment 5 of the present disclosure. Embodiment 5 provides a diffuser 1D including the microlens array 3, the transparent substrate 2, and a transparent layer 4 positioned between the microlens array 3 and the transparent substrate 2.

The microlens array 3 includes a plurality of lenses 10 that may be equal in shape to the plurality of lenses 10 according to any one of embodiments 1 to 4, or may be shaped differently.

The microlens array 3 and the transparent layer 4 may be different from each other in refractive index. The microlens array 3 may be made of an acrylic resin, an epoxy resin, or a silicone resin. The transparent layer 4 may be made of a material such as an acrylic resin, an epoxy resin, or a silicone resin, which are different in refractive index from the microlens array 3.

The microlens array 3 and the transparent layer 4 include a boundary surface S11 that may have unevenness. The unevenness may be gentle and have a continuous curvature.

In the diffuser 1D according to embodiment 5, the refracted light rays o11 and o12 incident on the foot portions of the lenses 10 at equal phases and traveling in a substantially same direction pass through the boundary surface S11 between the microlens array 3 and the transparent layer 4 to add variations to the phases of the refracted light rays o11 and o12. Accordingly reduced are interference fringes having phases provided with variations even when the refracted light rays o11 and o12 are applied to positions close to each other on the irradiation surface of diffused light. Furthermore, in embodiment 5, the diffuser 1D can reduce interference fringes as described above even if the lenses 10 do not have largely uneven vertex intervals. Therefore, the vertex intervals of the lenses 10 are set evenly or appropriately unevenly to achieve excellent light distribution characteristics.

<Light emitting device and sensor module>

FIG. 16 is a view of a light emitting device and a sensor module according to an embodiment of the present disclosure. The present disclosure provides a light emitting device 50 including a light emitting element 51 and the diffuser 1 positioned on a path of light emitted from the light emitting element 51. The diffuser 1 may be replaced with any one of the diffusers 1A to 1D according to embodiments 2 to 5. The diffuser 1 includes a lens surface (i.e., the microlens array 3) directed to the light emitting element 51. The light emitting element 51 may be configured to output laser light, and may alternatively be configured to emit light other than laser light. The light emitting element 51 may be accommodated in a package 52 having a cavity structure, and the diffuser 1 may be joined to the package 52. The diffuser 1 may also serve as a lid of the package 52.

The present embodiment provides a sensor module 100 including the light emitting device 50 configured to output diffused light and a light receiving device 60 configured to receive light emitted from the light emitting device 50 and reflected. The sensor module 100 may be configured for any direction such as LiDAR (light detection and ranging) or as a photoelectric sensor configured to detect whether or not there is any object on a light path. The light emitting device 50 and the light receiving device 60 may be mounted on a single module substrate 70 or on separate module substrates.

The light receiving device 60 includes a light receiving element 61 such as a photodiode. The light receiving device 60 may include a lens 62 configured to collect incident light to the light receiving element 61, and a filter element 63 configured to reduce a wavelength of incident light. The light receiving element 61 may be accommodated in a package 64, and the lens 62 and the filter element 63 may be supported by the package 64.

In the present embodiment, the light emitting device 50 includes any one of the diffuser 1 and 1A to 1D according to the embodiments so as to output diffused light having excellent light distribution characteristics with fewer interference fringes. In the present embodiment, the sensor module 100 includes any one of the diffuser 1 and 1A to 1D according to the embodiments so as to achieve highly reliable sensing with diffused light having excellent light distribution characteristics with fewer interference fringes.

The embodiments of the present disclosure have been described above. In the present disclosure, the diffuser, the light emitting device, and the sensor module are not limited to those according to the above embodiments. Details exemplified in the embodiments can be appropriately changed without departing from the purport of the present disclosure.

## INDUSTRIAL APPLICABILITY

The present disclosure is applicable to a diffuser, a light emitting device, and a sensor module.

## REFERENCE SIGNS

1, 1A to 1D diffuser
2 transparent substrate
3 microlens array
4 transparent layer
10, 10C lens
10A first lens
10B second lens
R1, R11 first shape region
R2, R12 second shape region
E1, E2 change point
k1, k1A, k1B, k1C, k2, k2A, k2B, k2C inclined portion
k3A, k3B, k4A, k4B width of concave arc portion
W1 width between change points
W3 width of concave arc portion
O1 optical axis
$\theta$ inclination angle of lens at change point
B0, vB0 boundary point
B1 boundary line

## Claims

**1.** A diffuser comprising a microlens array including a first lens, wherein

the first lens has an outline in a longitudinal section, the outline including a first shape region including an apex of the outline, a change point positioned at an end of the first shape region, and a second shape region positioned opposite to the first shape region to interpose the change point,
the first shape region has a shape according to formula (1),
the second shape region has a shape not according to formula (1) and includes a region larger in inclination angle than the shape according to formula (1), and
[Math. 1]

$$z = \frac{\frac{h^2}{r}}{1 + \sqrt{1 - \frac{(1+k)}{r^2} h^2}} \quad \cdots (1)$$

in which z is a sag, h is a distance from an optical axis, r is a lens radius, and k is a conic constant.

**2.** The diffuser according to claim 1, wherein

the microlens array includes a second lens disposed adjacent to the first lens,
the second lens has an outline in a longitudinal section, the outline including the first shape region, the change point, and the second shape region,
in a longitudinal section perpendicular to a boundary between the first lens and the second lens, the change point of the first lens and the change point of the second lens have a width corresponding to one-fiftieth or more of an average distance between vertexes and one-fourth or less of the average distance between vertexes, and
the average distance between vertexes is an average of distances between a vertex of the first lens and vertexes of a plurality of lenses in contact with the first lens.

**3.** The diffuser according to claim 1 or 2, wherein
the change point of the first lens is positioned along a boundary line of the first lens.

**4.** The diffuser according to any one of claims 1 to 3, wherein

the microlens array includes a second lens disposed adjacent to the first lens,
the second lens has an outline in a longitudinal section, the outline including the first shape region, the change point, and the second shape region,
in a longitudinal section, the first lens and the second lens have a boundary portion having a concave arc shape, and
the boundary portion has a width smaller than a width between the change point of the first lens and the change point of the second lens.

**5.** The diffuser according to claim 4, wherein
in a longitudinal section, the first lens and the second lens have a boundary point positioned higher than a boundary point between the first lens and the second lens in a case where the second shape region of the first lens and the second shape region of the second lens satisfy formula (1).

**6.** The diffuser according to any one of claims 1 to 5, wherein
the second shape region of the first lens has an elliptical shape.

**7.** A light emitting device comprising:

a light emitting element, and
the diffuser according to any one of claims 1 to 6, the diffuser being positioned on a path of light emitted from the light emitting element.

**8.** A sensor module comprising:

the light emitting device according to claim 7; and
a light receiving device configured to receive light emitted from the light emitting device.

FIG. 1A

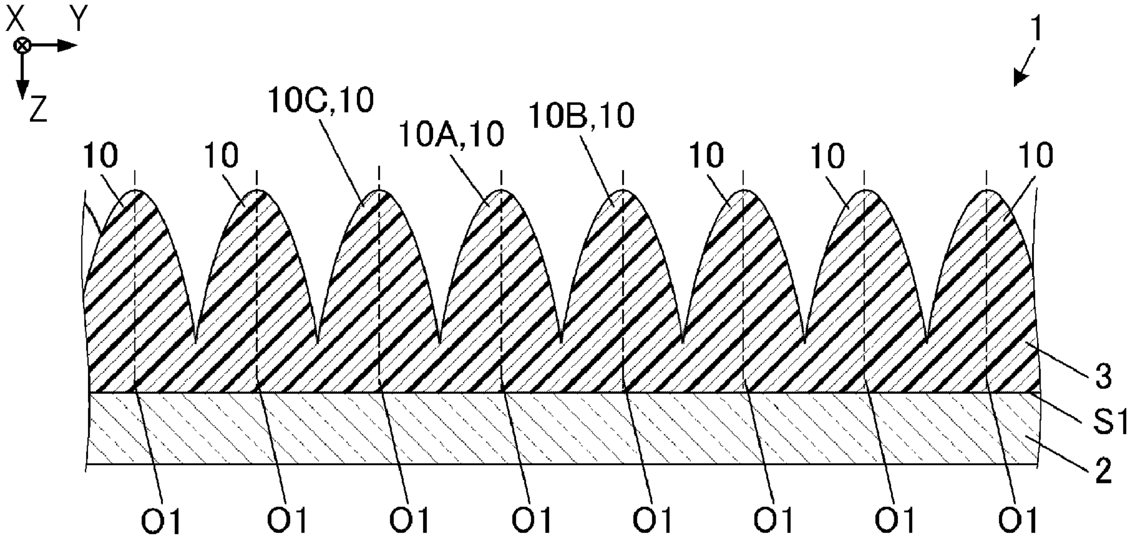


FIG. 1B

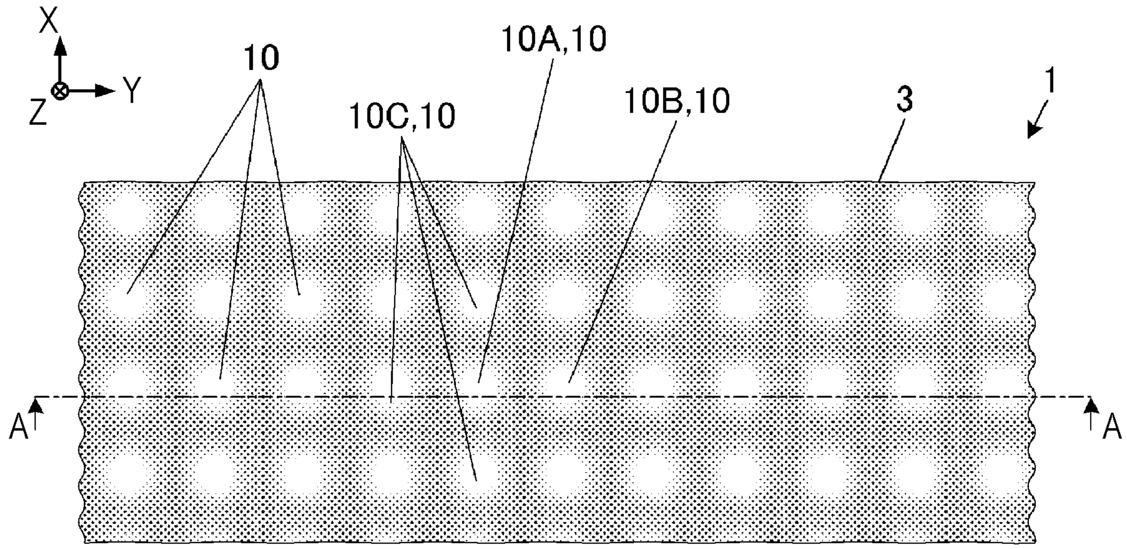


FIG. 1C

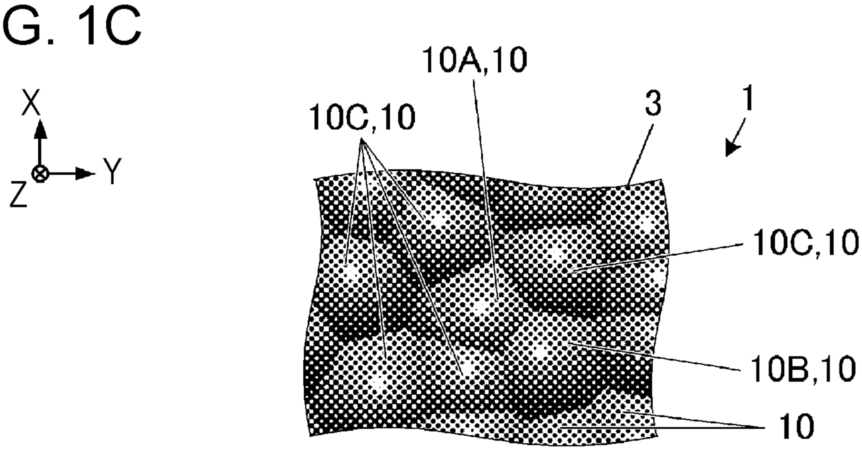

FIG. 2

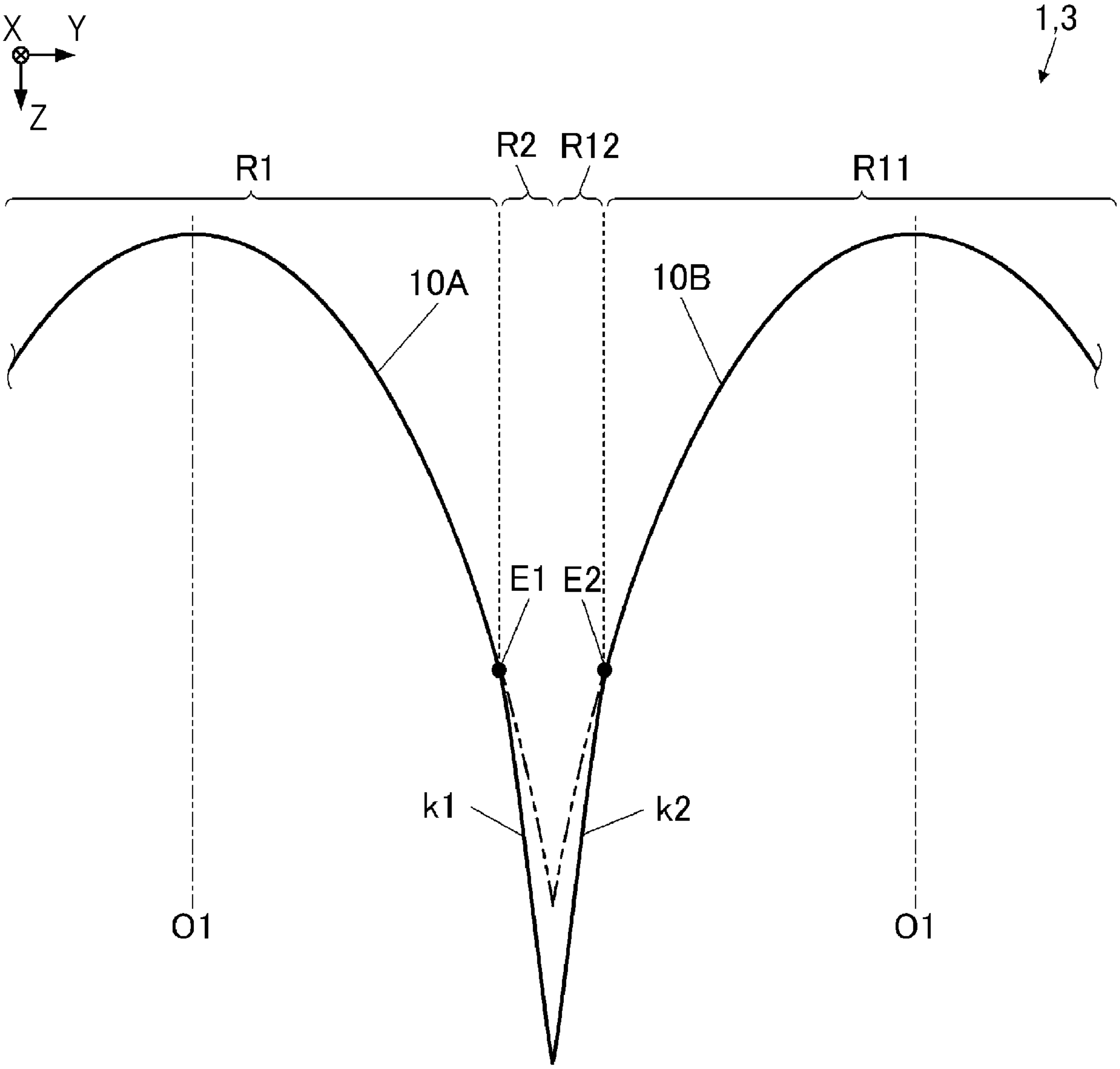

FIG. 3A

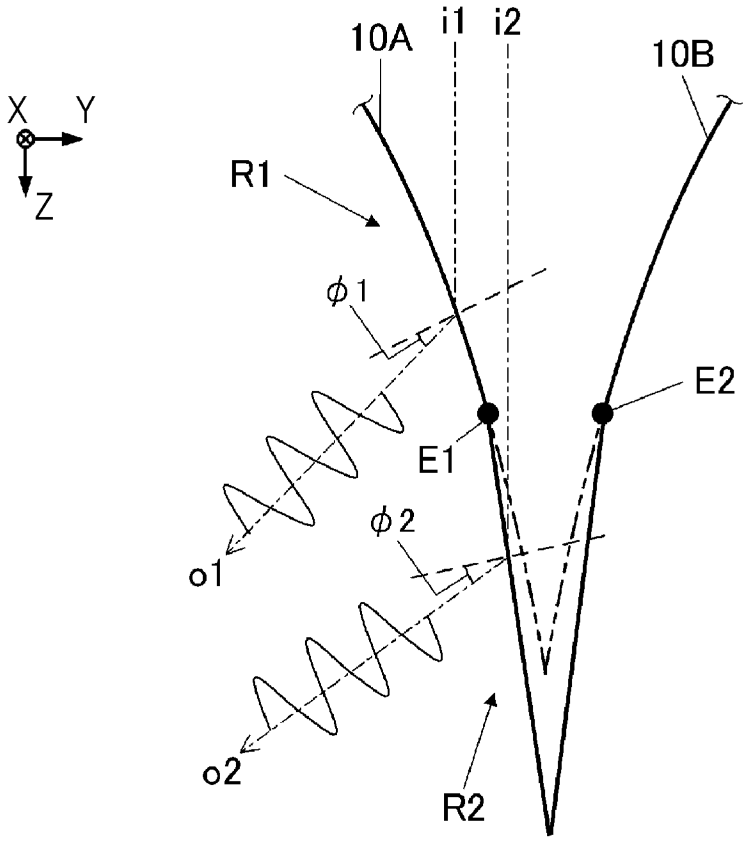
X
Y
Z
10A
i1
i2
10B
R1
φ1
E2
E1
φ2
o1
o2
R2

FIG. 3B

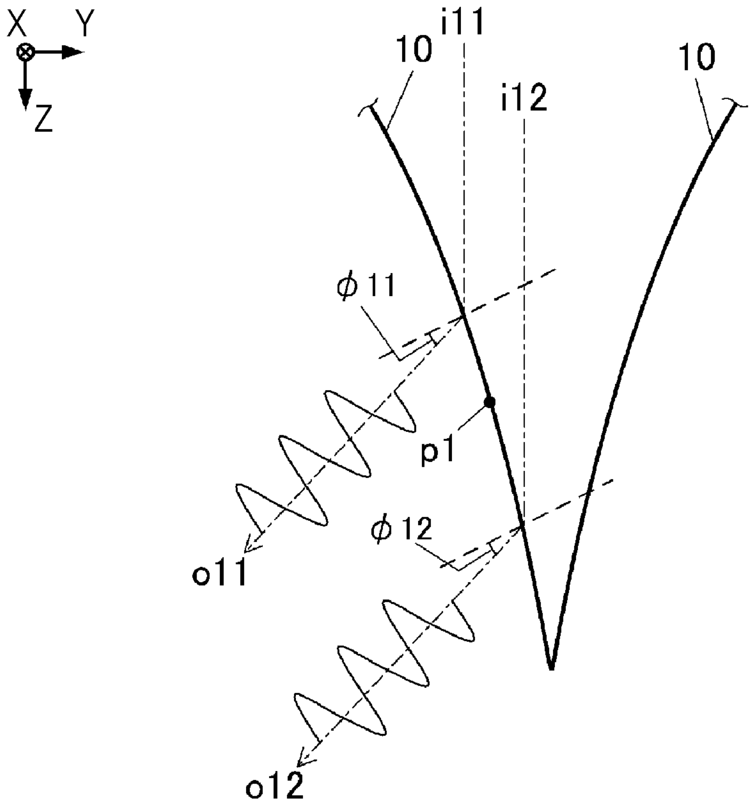
X
Y
Z
10
i11
10
i12
φ11
p1
φ12
o11
o12

FIG. 4A

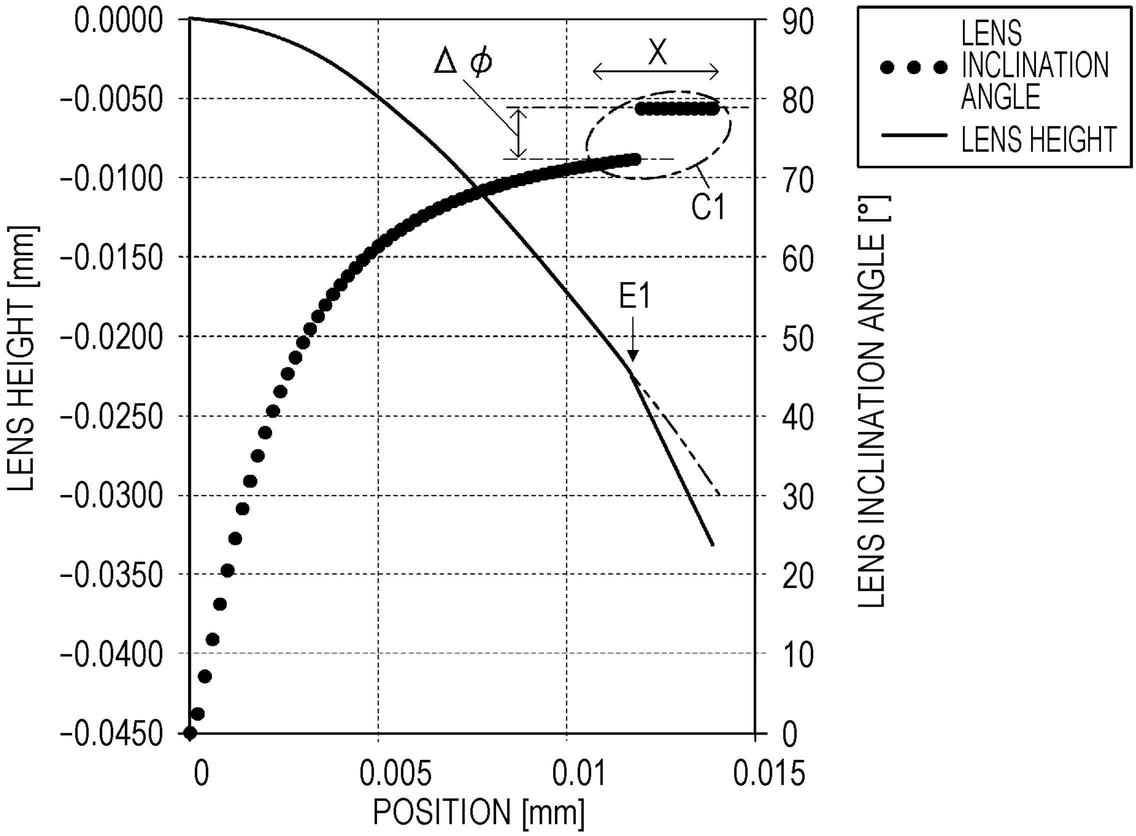
0.0000
-0.0050
-0.0100
-0.0150
-0.0200
-0.0250
-0.0300
-0.0350
-0.0400
-0.0450
LENS HEIGHT [mm]
Δ ϕ
X
C1
E1
90
80
70
60
50
40
30
20
10
0
LENS INCLINATION ANGLE [°]
0
0.005
0.01
0.015
POSITION [mm]
LENS INCLINATION ANGLE
LENS HEIGHT

FIG. 4B

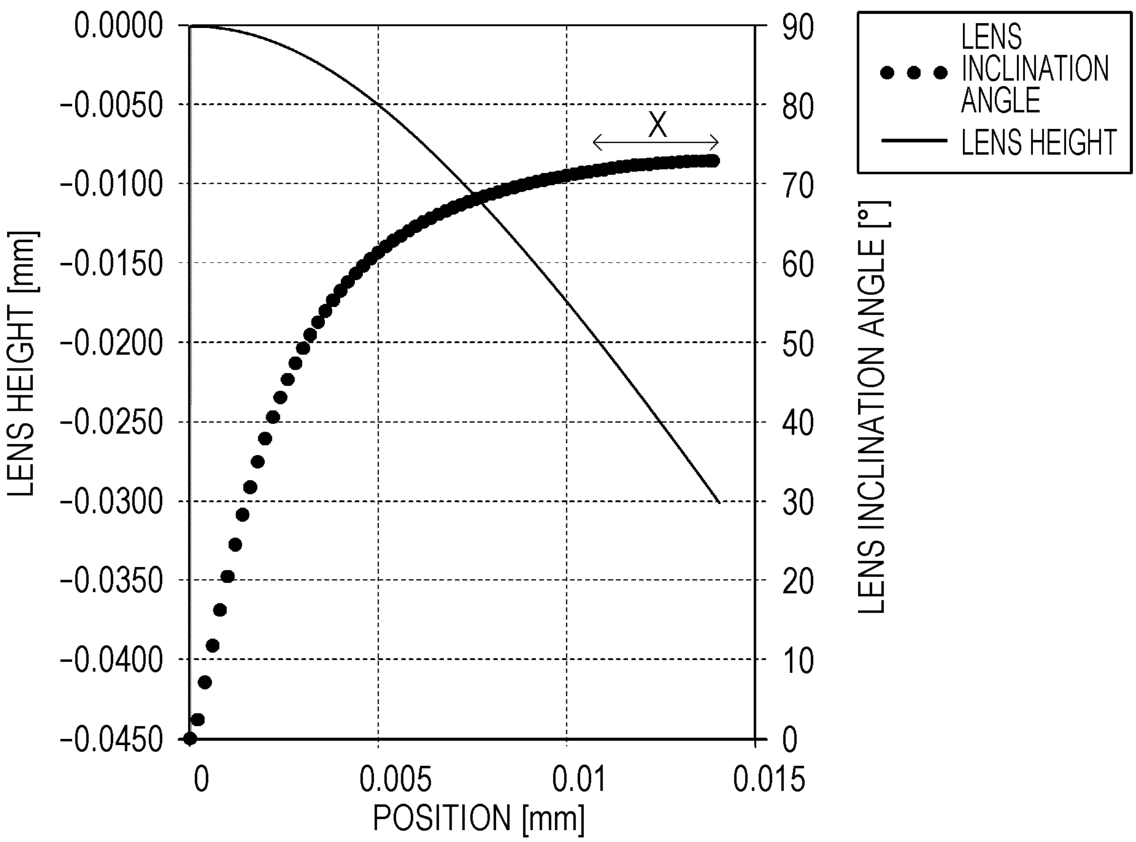
0.0000
-0.0050
-0.0100
-0.0150
-0.0200
-0.0250
-0.0300
-0.0350
-0.0400
-0.0450
LENS HEIGHT [mm]
X
90
80
70
60
50
40
30
20
10
0
LENS INCLINATION ANGLE [°]
0
0.005
0.01
0.015
POSITION [mm]
LENS INCLINATION ANGLE
LENS HEIGHT

FIG. 5

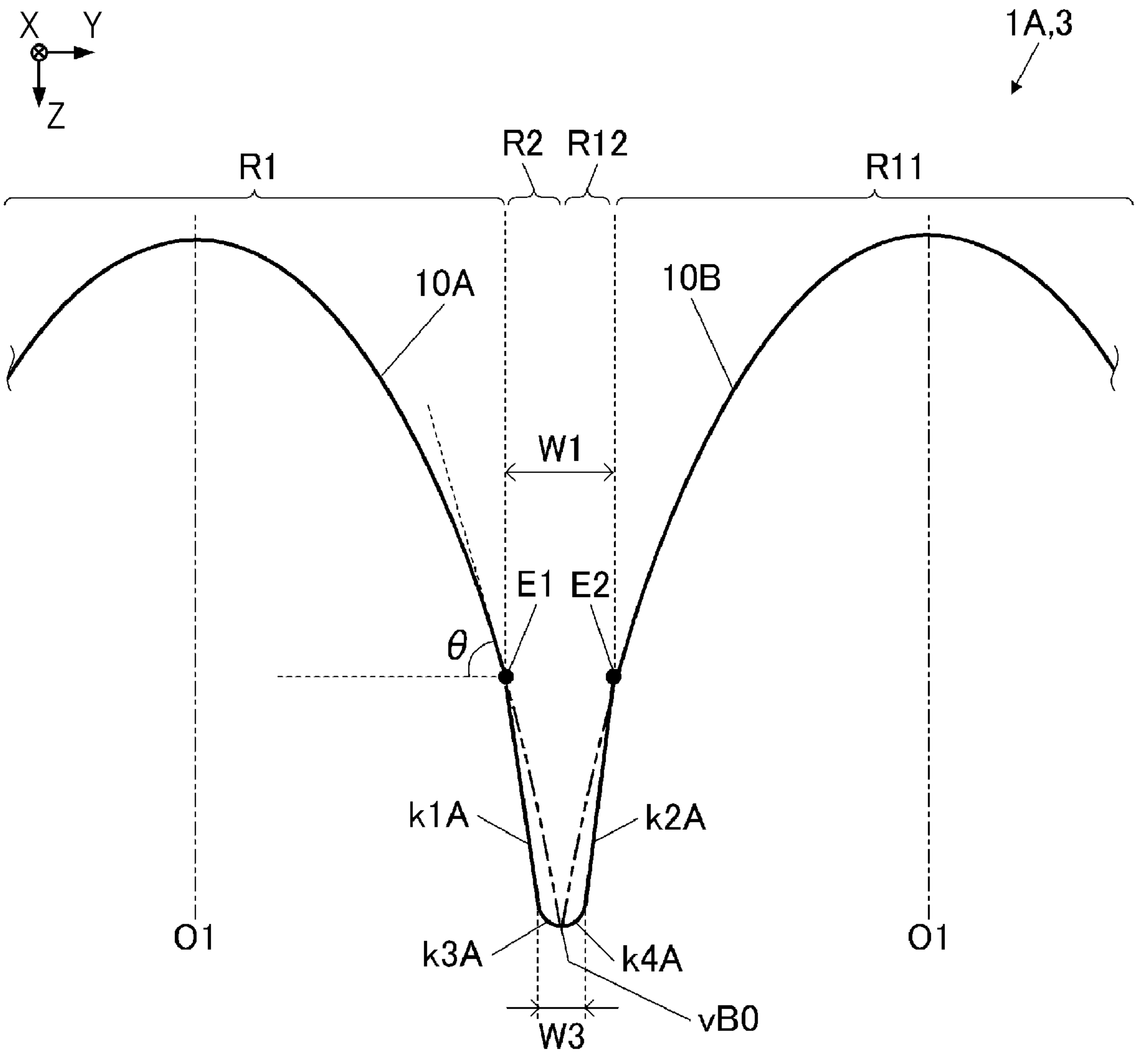
X Y
Z
1A,3
R1
R2
R12
R11
10A
10B
W1
E1
E2
θ
k1A
k2A
O1
O1
k3A
k4A
vB0
W3

FIG. 6

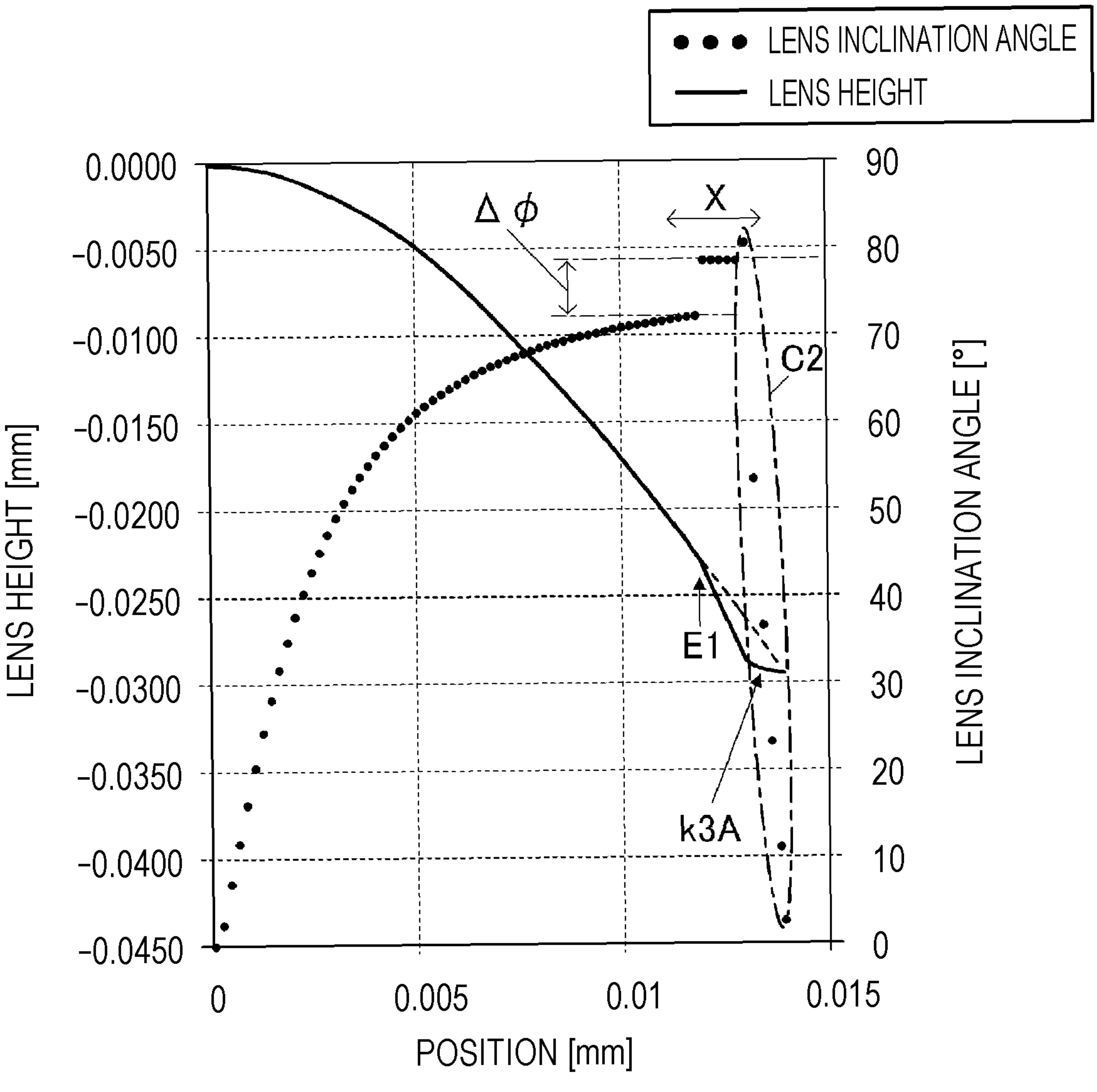
LENS INCLINATION ANGLE
LENS HEIGHT
0.0000
-0.0050
-0.0100
-0.0150
-0.0200
-0.0250
-0.0300
-0.0350
-0.0400
-0.0450
LENS HEIGHT [mm]
90
80
70
60
50
40
30
20
10
0
LENS INCLINATION ANGLE [°]
Δ ϕ
X
C2
E1
k3A
0
0.005
0.01
0.015
POSITION [mm]

FIG. 7A

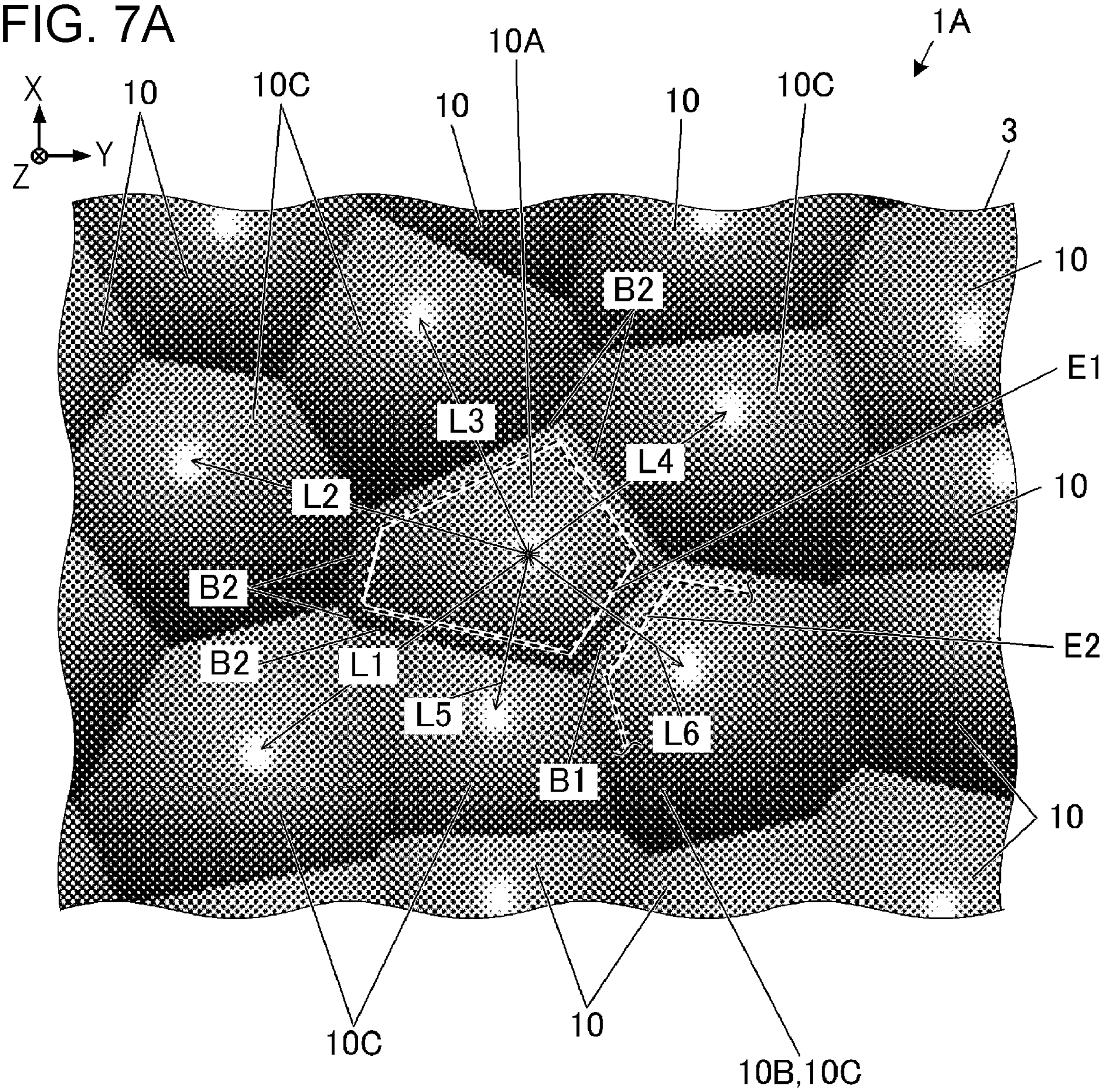
1A
10A
X
Y
Z
10
10C
10
10
10C
3
10
B2
E1
L3
L4
10
L2
B2
E2
B2
L1
L5
L6
B1
10
10C
10
10B,10C

FIG. 7B

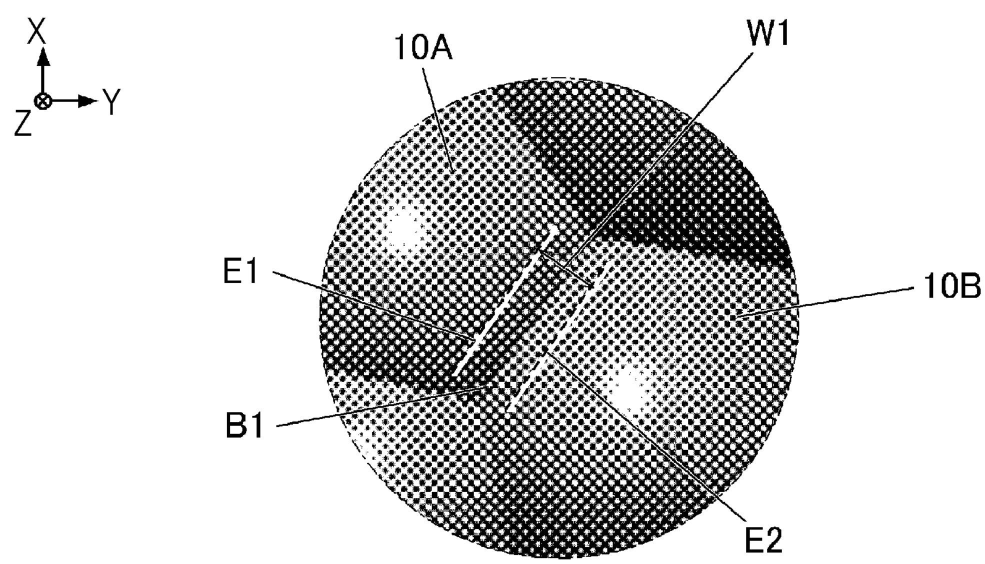
X
Y
Z
10A
W1
E1
10B
B1
E2

FIG. 8

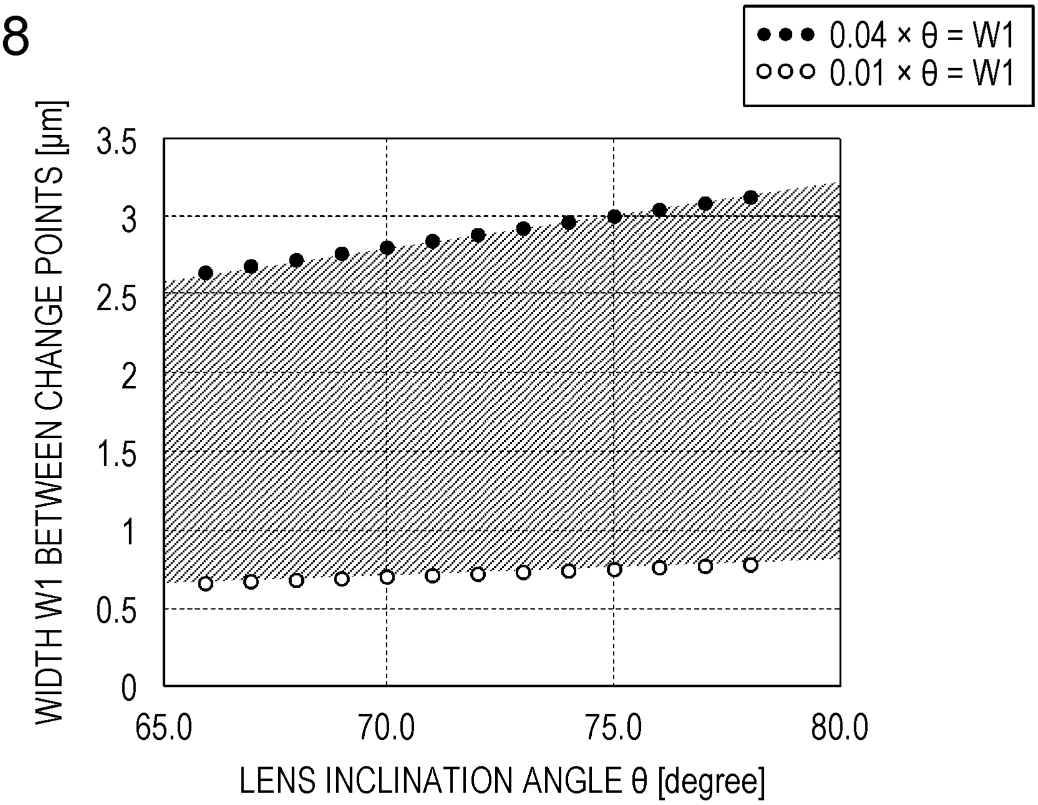
●●● 0.04 × θ = W1
○○○ 0.01 × θ = W1
WIDTH W1 BETWEEN CHANGE POINTS [µm]
3.5
3
2.5
2
1.5
1
0.5
0
65.0
70.0
75.0
80.0
LENS INCLINATION ANGLE θ [degree]

FIG. 9

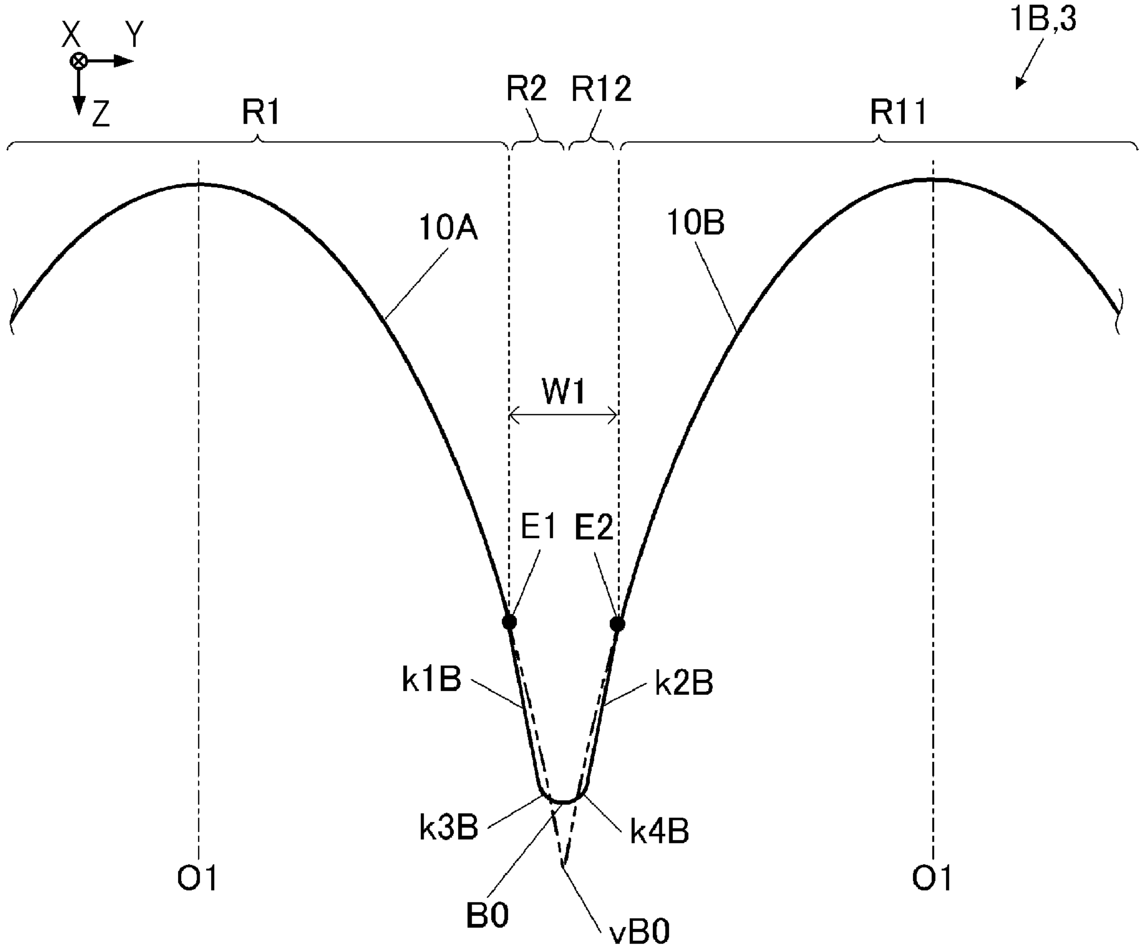
X
Y
Z
1B,3
R1
R2
R12
R11
10A
10B
W1
E1
E2
k1B
k2B
k3B
k4B
B0
vB0
O1
O1

FIG. 10

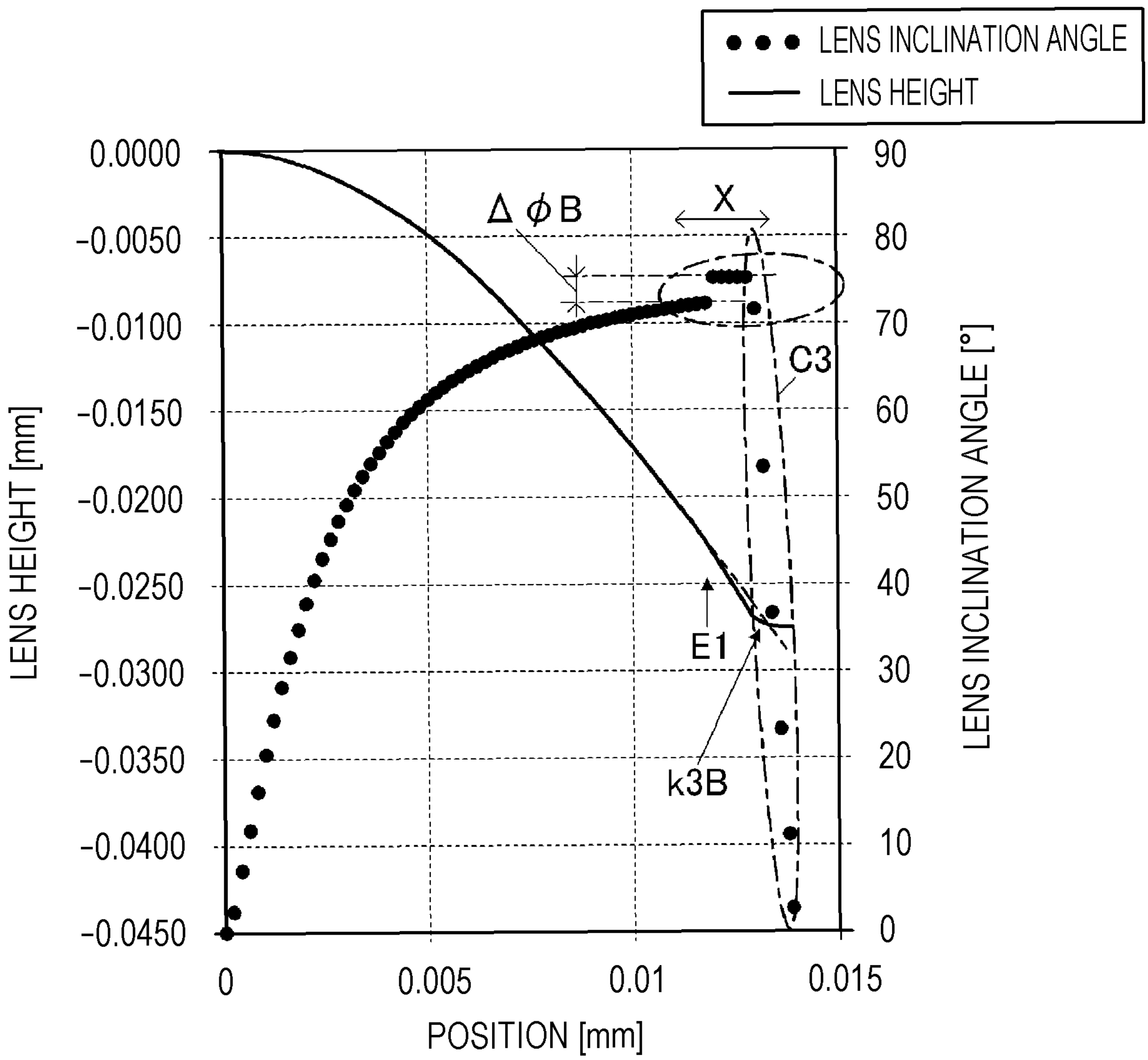
LENS INCLINATION ANGLE
LENS HEIGHT
LENS HEIGHT [mm]
LENS INCLINATION ANGLE [°]
POSITION [mm]
0.0000
-0.0050
-0.0100
-0.0150
-0.0200
-0.0250
-0.0300
-0.0350
-0.0400
-0.0450
90
80
70
60
50
40
30
20
10
0
0
0.005
0.01
0.015
Δ φB
X
C3
E1
k3B

FIG. 11A

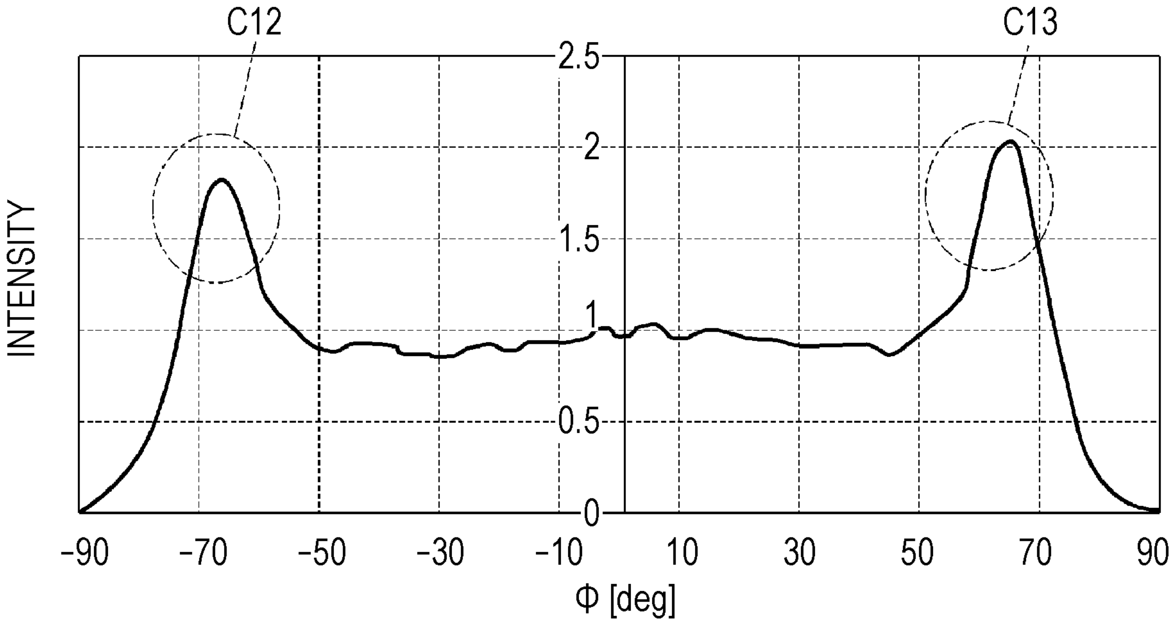


FIG. 11B

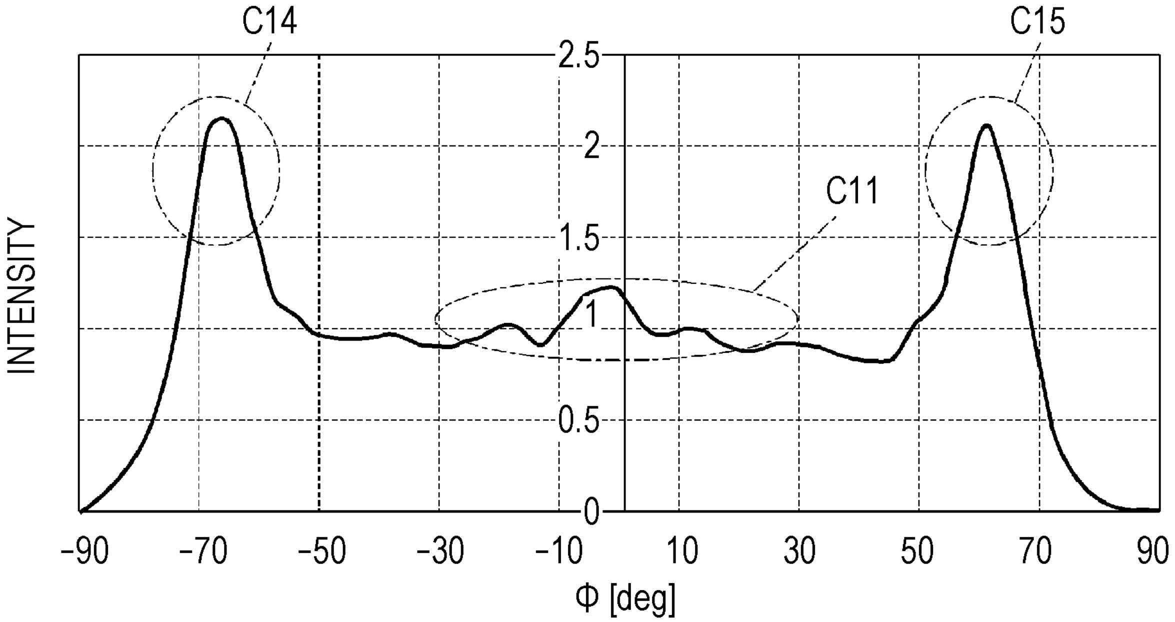

FIG. 12

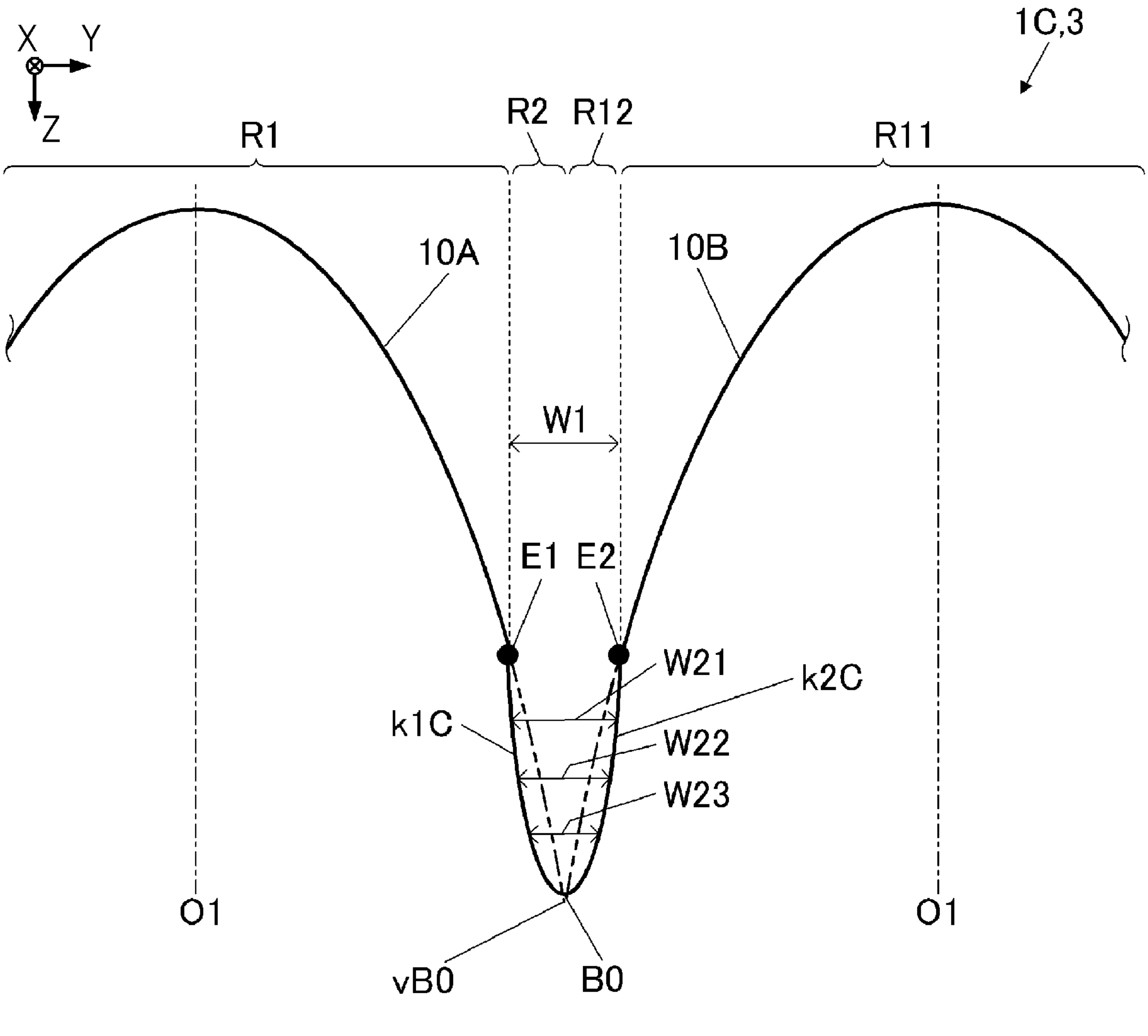
X
Y
Z
1C,3
R1
R2
R12
R11
10A
10B
W1
E1
E2
W21
k2C
k1C
W22
W23
O1
O1
vB0
B0

FIG. 13

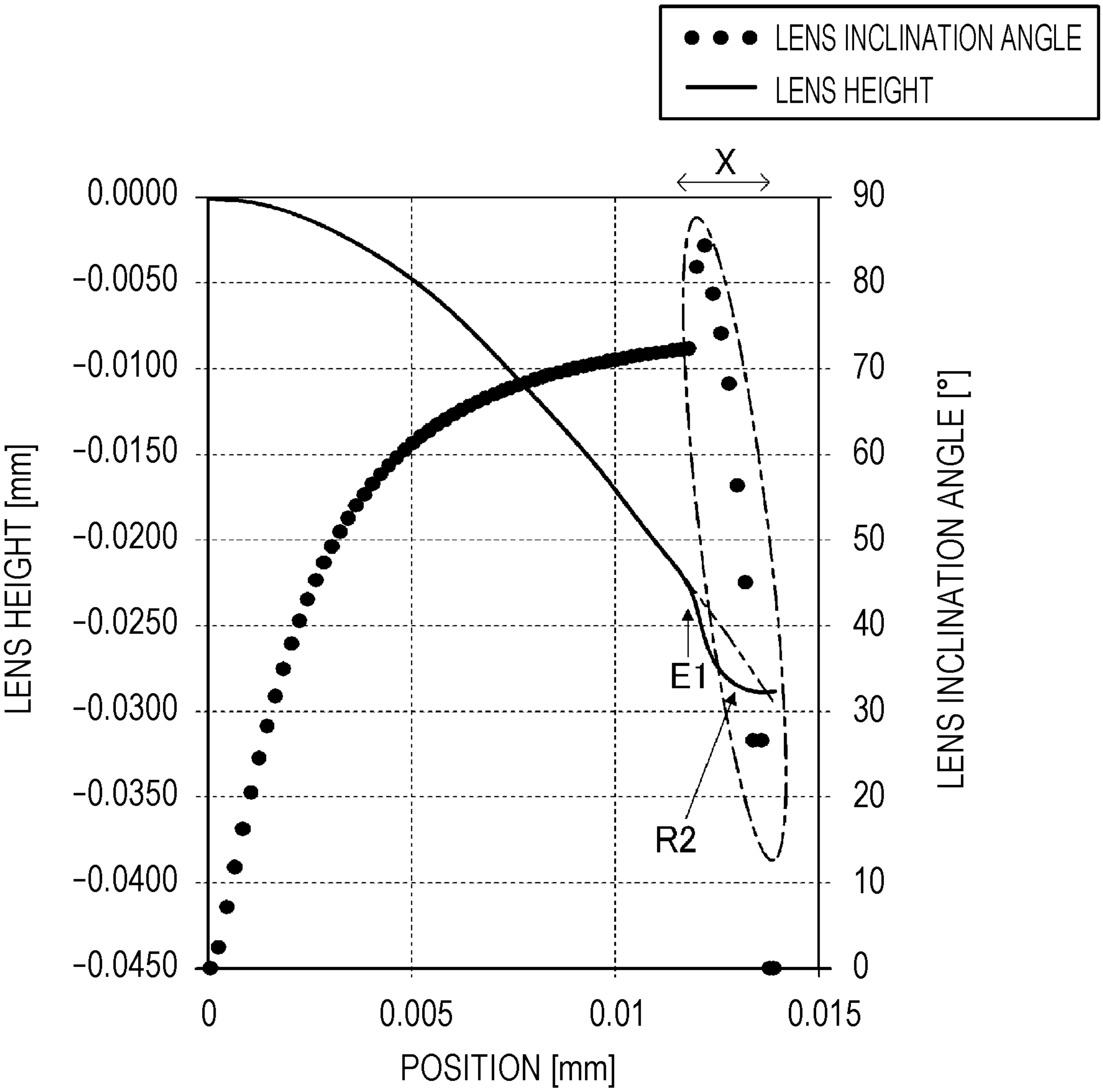
LENS INCLINATION ANGLE
LENS HEIGHT
X
0.0000
-0.0050
-0.0100
-0.0150
-0.0200
-0.0250
-0.0300
-0.0350
-0.0400
-0.0450
LENS HEIGHT [mm]
90
80
70
60
50
40
30
20
10
0
LENS INCLINATION ANGLE [°]
E1
R2
0
0.005
0.01
0.015
POSITION [mm]

FIG. 14

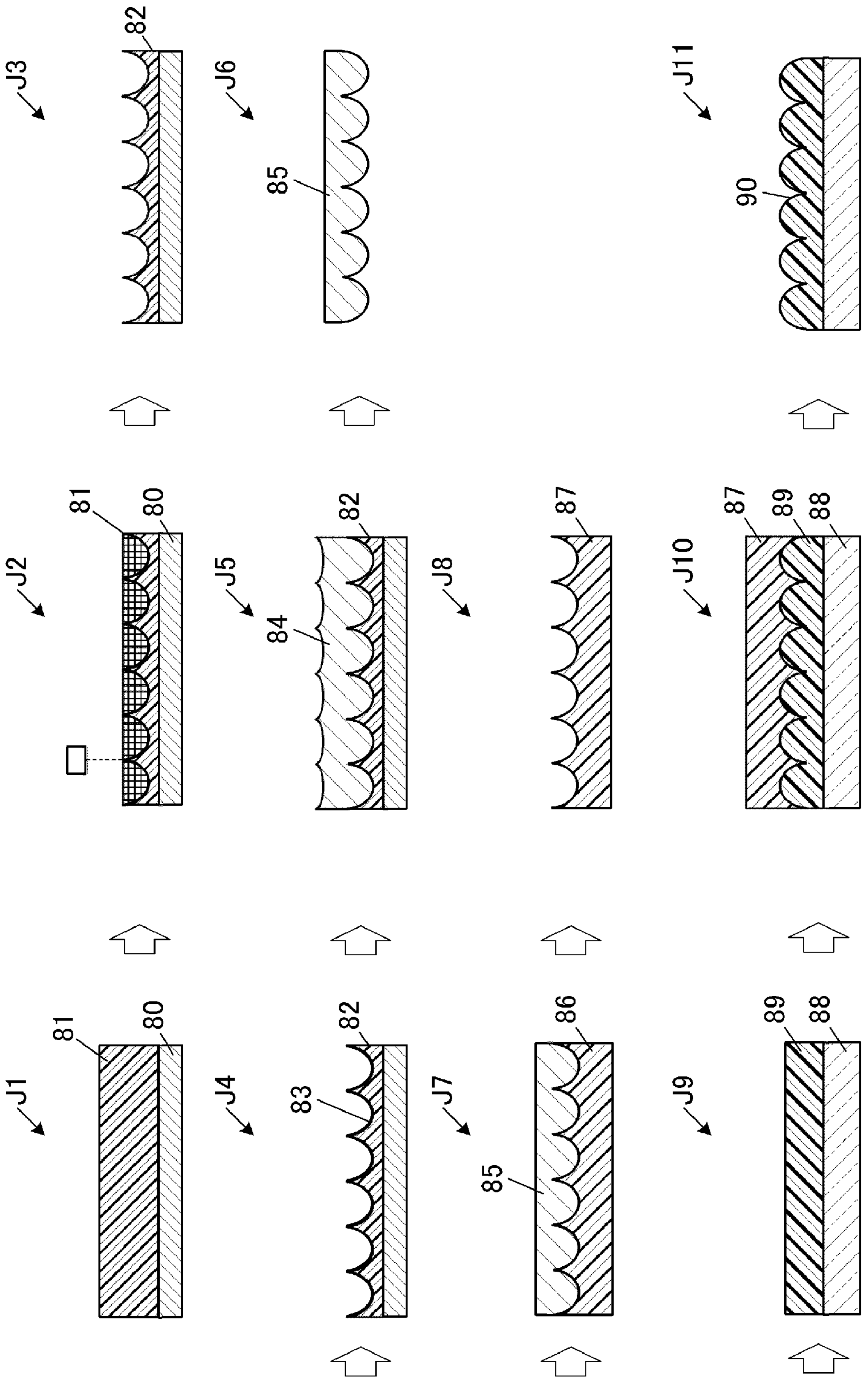
J1
81
80
J2
81
80
J3
82
J4
83
82
J5
84
82
J6
85
J7
85
86
J8
87
J9
89
88
J10
87
89
88
J11
90

FIG. 15

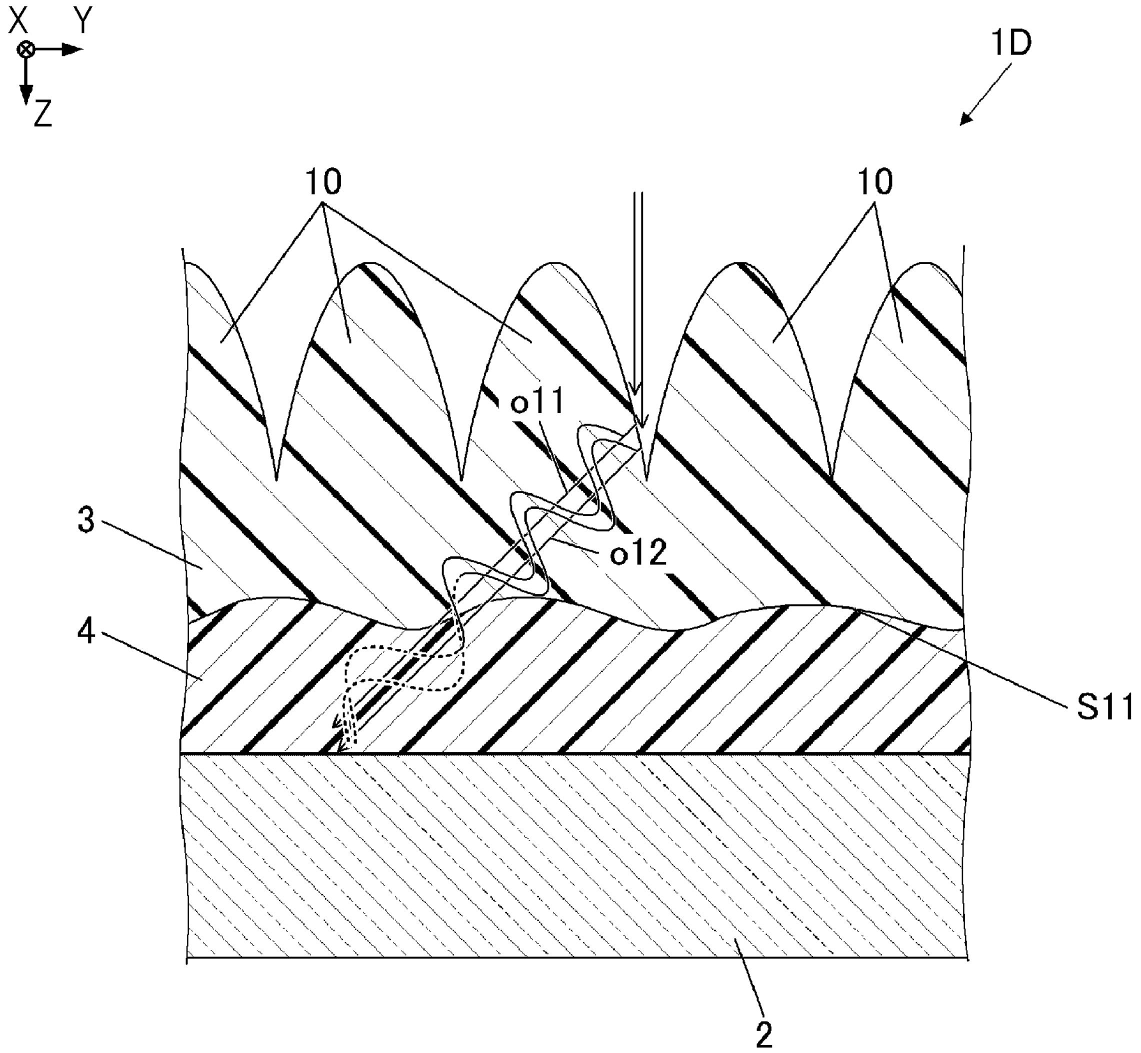

FIG. 16

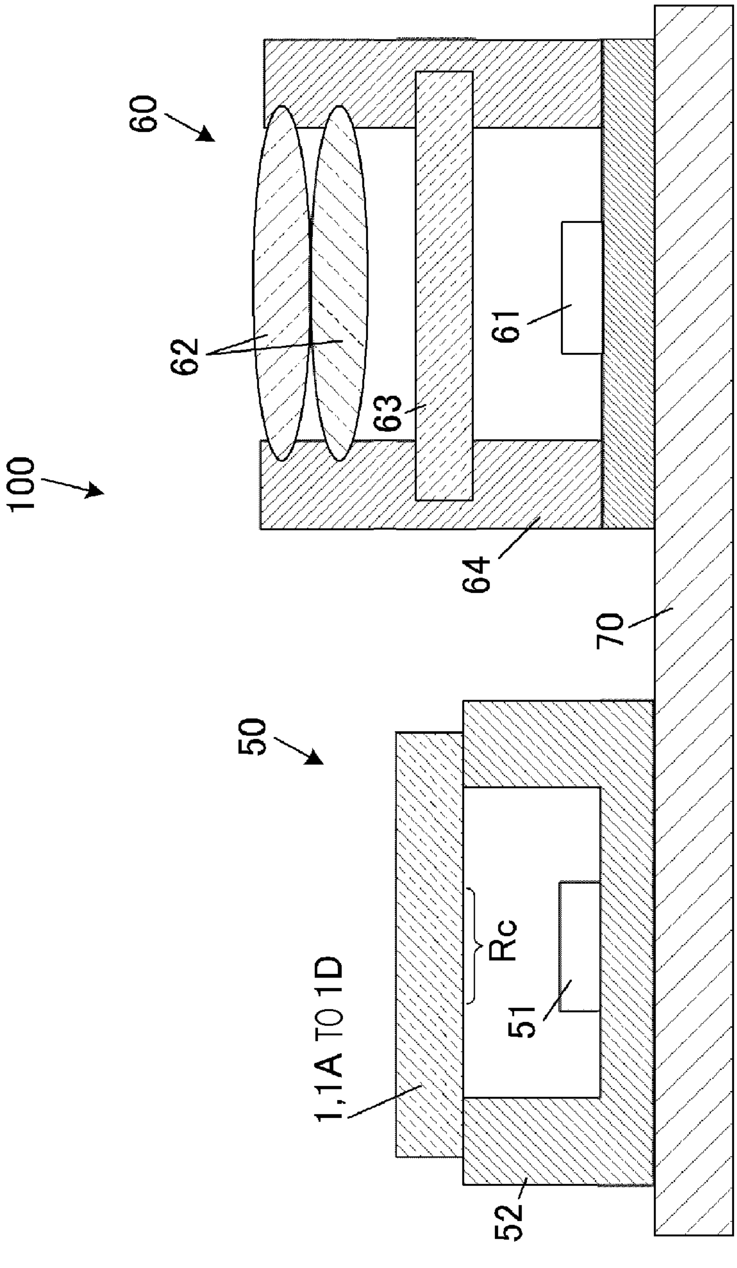

## INTERNATIONAL SEARCH REPORT

International application No.
**PCT/JP2023/008203**

**A. CLASSIFICATION OF SUBJECT MATTER**

***G02B 3/00***(2006.01)i; ***G02B 5/02***(2006.01)i; ***H01L 31/12***(2006.01)i
FI: G02B3/00 A; G02B5/02 C; H01L31/12 E

According to International Patent Classification (IPC) or to both national classification and IPC

**B. FIELDS SEARCHED**

Minimum documentation searched (classification system followed by classification symbols)

G02B3/00; G02B5/02; H01L31/12

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2014-38314 A (ASAHI GLASS CO., LTD.) 27 February 2014 (2014-02-27) paragraphs [0033]-[0035], [0050]-[0052], [0116], fig. 4 | 1-8 |
| A | JP 2011-53441 A (NIKON CORP.) 17 March 2011 (2011-03-17) entire text, all drawings | 1-8 |
| A | WO 2013/183708 A1 (DEXERIALS CORP.) 12 December 2013 (2013-12-12) entire text, all drawings | 1-8 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **29 March 2023** | **11 April 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2023/008203**

| Patent document cited in search report | Publication date (day/month/year) | Patent family member(s) | Publication date (day/month/year) |
|---|---|---|---|
| JP 2014-38314 A | 27 February 2014 | (Family: none) | |
| JP 2011-53441 A | 17 March 2011 | (Family: none) | |
| WO 2013/183708 A1 | 12 December 2013 | US 2015/0153483 A1<br>CN 104335080 A<br>JP 2013-254130 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003004907 A